# EUROPÄISCHE PATENTSCHRIFT

(11) **EP 0 442 021 B1**
(45) Veröffentlichungstag und Bekanntmachung des Hinweises auf die Patenterteilung: **26.04.1995**
(21) Anmeldenummer: 90103070.0
(22) Anmeldetag: 16.02.1990
(51) Int. Cl.: G11C 19/00, G11C 19/18

(54) **Schaltungsanordnung mit einer Vielzahl von dynamischen, taktsynchron betriebenen 1-Bit-Master-Slave-Registern**
Circuit device with a plurality of dynamic, synchronously clocked 1-bit-master-slave registers
Dispositif de circuit avec une pluralité de registres maître-esclave synchrones dynamiques d'un bit

(43) Veröffentlichungstag der Anmeldung: 21.08.1991
(73) Patentinhaber: SIEMENS AKTIENGESELLSCHAFT, 80333 München (DE)
(72) Erfinder: Brückner, Roland, Dipl.-Ing., D-8000 München 71 (DE)

(56) Entgegenhaltungen:
- US-A- 3 745 371
- IEEE JOURNAL ON SOLID-STATE CIRCUITS, Band 24, nr. 5, Oktober 1989, Seiten 1454-1458, New York, US; H.S. CHAO et al.: "Behavior analysis of CMOS D flip-flops"

## Beschreibung

Die Erfindung bezieht sich auf eine Schaltungsanordnung mit einer Vielzahl von dynamischen taktsynchron betriebenen 1-Bit Master-Slave-Schieberegistern, wobei die Master- und die Slave-Stufe eines Registers jeweils mit einem CMOS-Transmissionsglied und einem CMOS-Inverter gebildet ist.

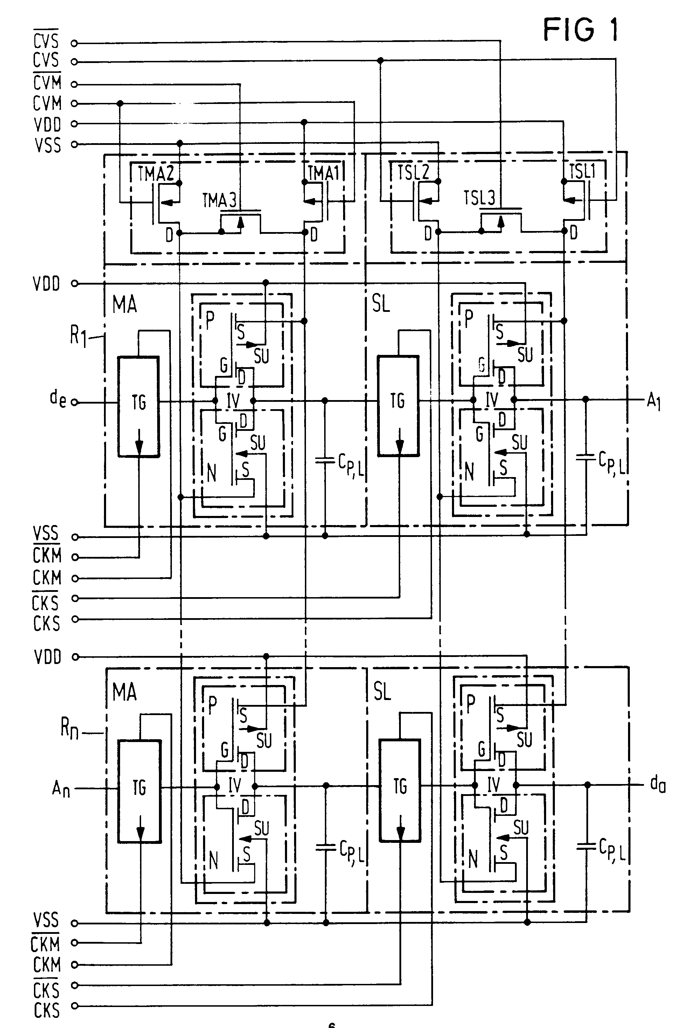

Eine derartige Anordnung von dynamischen taktsynchron betriebenen Master-Slave-Schieberegistern ist (z.B. aus I. Dobberpuhl, W. Daniel: Design and Analysis of V.L.S.I. Circuits TK 7874.G 573, 1985, FIG 1.48) bekannt.

Herkömmliche CMOS-Inverter sind aus einem P- und einem N-Kanal-Transistor zusammengesetzt, wobei die Gate-Anschlüsse der beiden Transistoren bzw. der Drain-Anschluß des P-Kanal-Transistors und der Drain-Anschluß des N-Kanal-Transistors jeweils miteinander verbunden sind. Der Substratanschluß sowie der Source-Anschluß des P-Kanal-Transistors sind an die eine CMOS-Betriebspotentialquelle VDD und der Substrat-Anschluß sowie der Source-Anschluß des N-Kanal-Transistors sind an die andere CMOS-Betriebspotentialqelle VSS angeschlossen. Liegt am Gate-Anschluß des P- und des N-Kanal-Transistors ein dem Betriebspotential VSS entsprechendes (VSS-)Signal an, dann leitet der P-Kanal-Transistor, während der N-Kanal-Transistor sperrt, die Ausgangsspannung entspricht dem VDD-Betriebspotential. Bei einer Eingangsspannung am Gate-Anschluß, die dem VDD-Betriebspotential entspricht, leitet der N-Kanal-Transistor und der P-Kanal-Transistor sperrt, die Ausgangsspannung entspricht dem VSS-Betriebspotential.
Entsprechend der Durchschaltecharakteristik von CMOS-Transistoren fließt während des Umschaltevorgangs ein Umladestrom, wobei die Höhe des Umladestroms hauptsächlich durch Umladevorgänge in Leitungskapazitäten und in den Raumladungszonen bestimmt wird.

In einer Schaltungsanordnung mit einer Vielzahl von dynamischen Master-Slave-Registern und mit einer entsprechenden Vielzahl von jeweils gleichzeitig ablaufenden Umladevorgängen kommt es zu einer entsprechenden Umladestromaufnahme, wobei der gestiegene Umladestrom einen höheren Leistungsverbrauch und dieser eine entsprechend erhöhte Wärmeentwicklung zur Folge hat. Ein hoher Umladestrom sowie eine erhöhte Wärmeentwicklung erweisen sich insbesondere in hochintegrierten CMOS-Schaltungen als nachteilig.

Der Erfindung liegt die Aufgabe zugrunde, einen Weg zu zeigen, wie bei einer Schaltungsanordnung der eingangs genannten Art der Leistungsverbrauch und eine damit verbundene Wärmeentwicklung verringert werden können.

Die Aufgabe wird bei einer Schaltungsanordnung der eingangs genannten Art erfindungsgemäß dadurch gelöst, daß die CMOS-Inverter einer Mehrzahl von Master-Stufen bzw. Slave-Stufen jeweils vom Substrat getrennte Source-Anschlüsse aufweisen, wobei der Source-Anschluß des Inverter-Transistors des einen Kanaltyps und der Source-Anschluß des Inverter-Transistors des anderen Kanaltyps jeweils in einem eigenen Stufentakt mit der zugehörigen CMOS-Betriebspotentialquelle VDD/VSS und gegenphasig zum jeweiligen Stufentakt miteinander verbunden sind.

Die Erfindung bringt in Verbindung mit gegenphasig zum jeweiligen Stufentakt bewirkten Potentialausgleichsvorgängen zwischen dem Source-Anschluß des Inverter-Transistors des einen Kanaltyps und dem Source-Anschluß des Inverter-Transistors des anderen Kanaltyps den Vorteil mit sich, daß bei einer nachfolgend wirksam werdenden Änderung der Eingangsspannung des CMOS-Inverters einer Master- bzw. Slave-Stufe nicht mehr der volle Spannungshub von VDD-Betriebspotential auf das VSS-Betriebspotential sowie vom VSS-Betriebspotential auf das VDD-Betriebspotential zur Erreichung der jeweiligen Ausgangsspannung stattfinden muß, so daß sich die Stromaufnahme der Registerstufe entsprechend reduziert.

In weiterer Ausgestaltung der Erfindung können die Substrat-Anschlüsse der P-Kanal-Transistoren bzw. die Substrat-Anschlüsse der N-Kanal-Transistoren der CMOS-Inverter der Master-Stufe sowie die der Slave-Stufe mit der CMOS-Betriebspotentialquelle VDD bzw. mit der CMOS-Betriebspotentialquelle VSS fest verbunden und die Source-Anschlüsse der P-Kanal-Transistoren bzw. die Source-Anschlüsse der N-Kanal-Transistoren der CMOS-Inverter der Master-Stufen sowie die der CMOS-Inverter der Slave-Stufen jeweils gesondert untereinander verbunden sein, was den Vorteil mit sich bringt, daß durch ein Zusammenschalten von unterschiedlichen Potentialen zwischen Ausgangsleitungen einer Mehrzahl von in gleichen Schaltzuständen gelangenden Master- sowie Slave-Invertern bereits vorab ein Potentialausgleich herbeigeführt und danach zur Erreichung der jeweiligen Ausgangsspannung der Inverter nur noch ein geringerer Spannungshub als beim einfachen Ladungsausgleich innerhalb einer Registerstufe benötigt wird, um vom CMOS-Betriebspotential VDD auf das CMOS-Betriebspotential VSS bzw. vom CMOS-Betriebspotential VSS auf das CMOS-Betriebspotential VDD zu gelangen.

In einer weiteren Ausgestaltung der Erfindung können jeweils untereinander verbundene Source-Anschlüsse der Master-Stufen bzw. Slave-Stufen im jeweiligen Stufen-Takt über P-Kanal-Transistoren an der CMOS-Betriebspotentialquelle VDD bzw. über N-Kanal-Transistoren an der CMOS-Betriebspotentialquelle VSS anliegen, wobei der Source-Anschluß der P-Kanal-Transistoren mit dem Source-Anschluß der N-Kanal-Transistoren über einen gegenphasig zum jeweiligen Stufentakt gesteuerten N-Kanal Transistor verbunden ist. Beim Ladungsausgleich fließen dann die Umladeströme der Leitungs- sowie Raumladungskapazitäten direkt über den jeweiligen gegenphasig zum jeweiligen Stufentakt gesteuerten N-Kanal-Transistor; die genannten Transistoren können dabei auf demselben integrierten CMOS-Baustein angeordnet werden, wobei die Taktzuführungen für den jeweiligen Stufen-Takt in günstiger Weise an die Schaltungsperipherie gelegt werden können. Durch eine zwischen zwei Register-Stufen wirksame Querkapazität, bestehend aus parasitären Kapazitäten und/oder Lastkapazitäten kann bei zumindest angenähert statistischer Verteilung der Digitalsignalpegel "1" und "0" und bei einer hinreichend großen Anzahl von Master-Slave-Registern der jeweilige stufeninterne Spannungsausgleich auf etwa VDD/2 reduziert werden. Im Idealfall ergibt sich eine Reduzierung der Stromaufnahme von etwa 50 %.
Eine hohe Verlustleistung, sowie ein Ansteigen der Wärmeentwicklung in den hochintegrierten Schaltungsanordnungen eines dynamischen Master-Slave-Registers sowie eintretende Spannungseinbrüche bei Worst-Gase-Betrachtungen können vermieden werden. Wegen des geringeren Spannungshubes bis zur Erreichung der jeweiligen Ausgangsspannung können die Inverter der Master- und Slave-Stufen auch entsprechend schwächer ausgelegt werden.

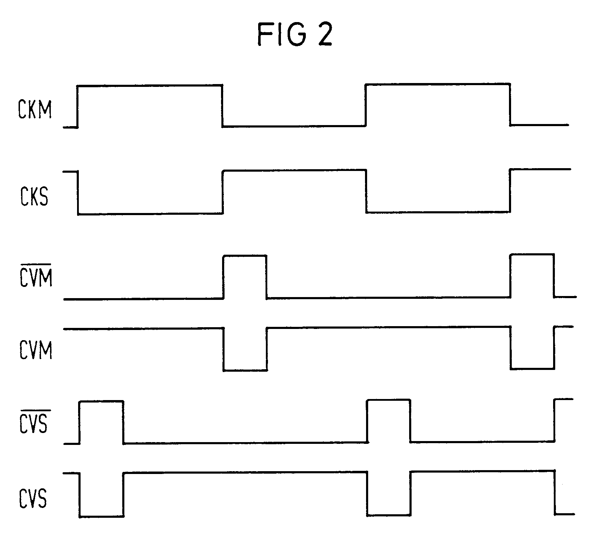

Weitere Besonderheiten der Erfindung werden aus der nachfolgenden näheren Erläuterung eines Ausführungsbeispiels anhand FIG 1 sowie aus den dazugehörigen Zeitdiagrammen in FIG 2 ersichtlich.

In der Zeichnung FIG 1 ist eine Schaltungsanordnung mit einer Vielzahl von dynamischen, taktsynchron betriebenen 1-Bit-Master-Slave-Registern R₁,...,Rₙ dargestellt, wobei die Master-Stufe MA und die Slave-Stufe SL eines Registers R jeweils mit einem CMOS-Transmissionsglied TG und einem CMOS-Inverter IV gebildet ist. Die CMOS-Inverter IV einer Mehrzahl von Master-Stufen MA weisen ebenso wie die CMOS-Inverter IV einer Mehrzahl von Slave-Stufen SL jeweils vom Substrat SU getrennte Source-Anschlüsse S auf. Die Source-Anschlüsse S des P-Kanal Transistors und die Source-Anschlüsse S des N-Kanal-Transistors sind jeweils miteinander verbunden und in einem eigenen Stufentakt, dem Master-Takt CVM (vgl. auch FIG 2), dem Slave-Takt CVS (vgl. FIG 2) über einen P-Kanal-Transistor TMA1 bzw. TSL1 mit der CMOS-Betriebspotentialquelle VDD und über einen N-Kanal-Transistor TMA2 bzw. TSL2 mit der CMOS-Betriebspotentialquelle VSS verbunden.

Die Substrat-Anschlüsse SU der P-Kanal-Transistoren P bzw. die Substrat-Anschlüsse SU der N-Kanal-Transistoren N der CMOS-Inverter der Master-Stufen MA sowie der Slave-Stufen SL liegen an der CMOS-Betriebspotentialquelle VDD bzw. an der CMOS-Betriebspotentialquelle VSS fest an.

Ein CMOS-N-Kanal-Transistor TMA3 verbindet gegenphasig zum jeweiligen Stufentakt CVM den Drain-Anschluß D des P-Kanal-Transistors TMA1 mit dem Drain-Anschluß D des N-Kanal-Transistors TMA2 der Master-Stufe MA, ein CMOS-N-Kanal-Transistor TSL3 verbindet gegenphasig zum jeweiligen Stufentakt CVS den Drain-Anschluß des P-Kanal-Transistors TSL1 und den Drain-Anschluß des N-Kanal-Transistors TSL2 der Slave-Stufe SL.
Eine Querkapazität C_{P, L} bestehend aus parasitären Kapazitäten sowie Lastkapazitäten befindet sich zwischen zwei Register-Stuen. Das Transmissionsglied TG in der Master-Stufe wird mit dem Takt CKM und C̅K̅M̅ und das Transmissionsglied in der Slave-Stufe wird mit dem Takt CKS und C̅K̅S̅ beaufschlagt.
Die Master-Slave-Register R₁,...,Rₙ sind über Verbindungen A₁,...,Aₙ aneinandergekettet, wobei die Digitaldaten am Eingang dₑ des ersten Master-Slave-Registers R₁ zugeführt und am Ausgang dₐ des letzten Master-Slave-Registers Rₙ ausgegeben werden. Entsprechend den Stufentakten CVM, C̅V̅M̅ bzw. CVS, C̅V̅S̅ der Master-Slave-Register R, wie in den Zeitdiagrammen in FIG 2, Zeile 3 bis 6 angedeutet, gelangen bei geöffnetem Transmissionsglied TG der Master-Stufe MA die Digitalsignale an die Eingänge G des Inverters IV der Master-Stufe MA und bewirkten dort entsprechend dem Pegel des Digitalsignals die Durchschaltung des N-Kanal-Transistors oder des P-Kanal-Transistors. Nachdem die Source-Anschlüsse S der P-Kanal-Transistoren der Inverter IV der Master-Stufen MA von dem Betriebspotential VDD und die Source-Anschlüsse S der N-Kanal-Transistoren der Inverter IV der Master-Stufen MA von dem Betriebspotential VSS getrennt wurden, öffnet der Transistor TMA3 und ermöglicht damit einen Ladungsausgleich der Querkapazitäten C_{P, L} der Master-Stufen MA so daß das Potential am Ausgang der Inverter in den Master-Stufen MA auf etwa VDD/2 anwachsen kann:

Wenn zum Beispiel an den Eingängen G des Inverters IV der Master-Stufe MA des Registers R₁ ein Digitalsignal mit dem Digitalsignalpegel "1" und an den Eingängen G des Invertes IV der Master-Stufe MA eines weiteren Registers Rₙ ein Digitalsignal mit dem Digitalsignalpegel "0" anliegt, sind der N-Kanal-Transistor der Master-Stufe MA des Registers R₁ und der P-Kanal-Transistor der Master-Stufe MA des Registers Rₙ leitend. Den aus FIG 2 ersichtlichen Taktzuständen folgend kann ein Ladungsausgleich von der Querkapazität C_{P, L} der Registerstufe Rₙ über den leitenden P-Kanal-Transistor des Inverters IV der Master-Stufe MA, den leitenden Verbindungstransistor TMA3 und den leitenden N-Kanal-Transistor des Inverters IV der Master-Stufe MA der Registerstufe R₁ zu deren Querkapazität C_{P, L} hin erfolgen. Eine weitere Möglichkeit eines Ladungsausgleichs der Querkapazitäten C_{P, L} in den Registerstufen R kann z. B. über die jeweils gesondert untereinander verbundenen Source-Anschlüsse S der P-Kanal-Transistoren der CMOS-Inverter IV der Master-Stufen MA bei jeweils gleichem Eingangspotential einem dem VSS-Betriebspotential entsprechendem (VSS-) Signal am Gate der Inverter IV der Master-Stufen erfolgen. In entsprechender Weise kann ein Ladungsausgleich auch zwischen den Querkapazitäten C_{P, L} in den Slave-Stufen SL der Register R vonstatten gehen.

## Patentansprüche

1. Schaltungsanordnung mit einer Vielzahl von dynamischen, taktsynchron betriebenen 1-Bit-Master-Slave-Registern, wobei die Master- (MA) und die Slave-Stufe (SL) eines Registers (R₁,..., Rₙ) jeweils mit einem CMOS-Transmissionsglied (TG) und einem CMOS-Inverter (IV) gebildet ist,
**dadurch gekennzeichnet,**
daß die CMOS-Inverter einer Mehrzahl von Master-Stufen (MA) bzw. Slave-Stufen (SL) jeweils vom Substrat (SU) getrennte Source-Anschlüsse (S) aufweisen, wobei der Source-Anschluß (S) des Inverter-Transistors des einen Kanaltyps (P) und der Source-Anschluß (S) des Inverter-Transistors des anderen Kanaltyps (N) jeweils in einem eigenen Stufentakt (Master-(CVM) bzw. Slave-Takt (CVS)) mit der zugehörigen CMOS-Betriebspotentialquelle (VDD, VSS) und gegenphasig zum jeweiligen Stufentakt (C̅V̅M̅, C̅V̅S̅) miteinander verbunden sind.

2. Schaltungsanordnung nach Anspruch 1,
**dadurch gekennzeichnet,**
daß die Substrat-Anschlüsse (SU) der P-Kanal-Transistoren (P) bzw. die Substrat-Anschlüsse (SU) der N-Kanal-Transistoren (N) der CMOS-Inverter der Master-Stufe (MA) sowie die der Slave-Stufe (SL) an der einen CMOS-Betriebspotentialquelle (VDD) bzw. an der anderen CMOS-Betriebspotentialquelle (VSS) fest anliegen, daß die Source-Anschlüsse (S) der P-Kanal-Transistoren (P) bzw. die Source-Anschlüsse (S) der N-Kanal-Transistoren (N) der CMOS-Inverter der Master-Stufen (MA) sowie die der CMOS-Inverter der Slave-Stufen (SL) jeweils gesondert untereinander verbunden sind.

3. Schaltungsanordnung nach Anspruch 2,
**dadurch gekennzeichnet,**
daß die jeweils untereinander verbundenen Source-Anschlüsse der Master-Stufen bzw. Slave-Stufen im jeweiligen Stufentakt über P-Kanal-Transistoren (TMA1, TSL1) an der einen CMOS-Betriebspotentialquelle (VDD) bzw. über N-Kanal-Transistoren (TMA2, TSL2) an der anderen CMOS-Betriebspotentialquelle (VSS) anliegen, wobei der Drain-Anschluß des P-Kanal-Transistors (TMA1, TSL1) mit dem Drain-Anschluß des N-Kanal-Transistors (TMA2, TSL2) über einen gegenphasig zum jeweiligen Stufentakt gesteuerten N-Kanal-Transistor (TMA3, TSL 3) verbunden ist.

## Claims

1. Circuit arrangement having a multiplicity of dynamic i-bit master-slave registers which are operated in a clock-synchronous manner, the master stage (MA) and the slave stage (SL) of a register (R₁, ..., Rₙ) in each case being formed by a CMOS transmission element (TG) and a CMOS invertor (IV), characterized in that the CMOS invertors of a plurality of master stages (MA) and/or slave stages (SL) in each case have source connections (S) which are isolated from the substrate (SU), the source connection (S) of the invertor transistor of one conductance type (P) and the source connection (S) of the invertor transistor of the other conductance type (N) in each case being connected to one another in a dedicated stage clock (master (CVM) or slave clock (CVS)) with the associated CMOS operating-potential source (VDD, VSS) and in antiphase to the respective stage clock (C̅V̅M̅, C̅V̅S̅).

2. Circuit arrangement according to Claim 1, characterized in that the substrate connections (SU) of the P-conductance-type transistors (P) and the substrate connections (SU) of the N-conductance-type transistors (N) of the CMOS invertors of the master stage (MA) and those of the slave stage (SL) are permanently connected to one CMOS operating-potential source (VDD) or, respectively, to the other CMOS operating-potential source (VSS), in that the source connections (S) of the P-conductance-type transistors (P) and the source connections (S) of the N-conductance-type transistors (N) of the CMOS invertors of the master stages (MA) and those of the CMOS invertors of the slave stages (SL) are in each case connected to one another separately.

3. Circuit arrangement according to Claim 2, characterized in that the source connections, which are respectively connected to one another, of the master stages and of the slave stages are connected in the respective stage clock via P-conductance-type transistors (TMA1, TSL1) to one CMOS operating-potential source (VDD) or, respectively, via N-conductance-type transistors (TMA2, TSL2) to the other CMOS operating-potential source (VSS), the drain connection of the P-conductance-type transistor (TMA1, TSL1) being connected to the drain connection of the N-conductance-type transistor (TMA2, TSL2) via an N-conductance-type transistor (TMA3, TSL3) which is controlled in antiphase to the respective stage clock.

## Revendications

1. Montage comportant une multiplicité de registres dynamiques maîtres-esclaves à 1 bit, fonctionnant avec des cadences synchrones, l'étage maître (MA) et l'étage esclave (SL) d'un registre (R₁,...,Rₙ) étant formés respectivement par un circuit de transmission CMOS (TG) et par un inverseur CMOS (IV), caractérisé par le fait que les inverseurs CMOS d'une multiplicité d'étages maîtres (MA) ou d'étages esclaves (SL) possèdent des bornes de source (S) séparées respectivement du substrat (SU), la borne de source (S) du transistor inverseur possédant un type de canal (P) et la borne de source (S) du transistor inverseur possédant l'autre type de canal (N) étant reliées respectivement, selon une cadence propre d'étage (cadence maître (CVM) ou cadence esclave (CVS)), à la source associée de potentiel de fonctionnement CMOS (VDD,VSS) et entre elles en opposition de phase par rapport à la cadence d'étage respective (C̅V̅M̅, C̅V̅S̅).

2. Montage suivant la revendication 1, caractérisé par le fait que les bornes de substrat (SU) des transistors (P) à canal P ou les bornes de substrat (SU) des transistors (N) à canal N des inverseurs CMOS de l'étage maître (MA) ainsi que ceux de l'étage esclave (SL) sont raccordés de façon fixe à une source de potentiel de fonctionnement CMOS (VDD) ou à l'autre source de potentiel de fonctionnement CMOS (VSS), que les bornes de source (S) des transistors (P) à canal P ou les bornes de source (S) des transistors (N) à canal N des inverseurs CMOS des étages maîtres (MA) ainsi que ceux des inverseurs CMOS des étages exclaves (SL) , sont séparément reliées respectivement entre elles.

3. Montage suivant la revendication 2, caractérisé par le fait que les bornes de source, qui sont reliées respectivement entre elles, des étages maîtres et des étages esclaves sont reliées, lors de la cadence d'étage respective, par l'intermédiaire de transistors à canal P (TMA1, TSL1), à une source de potentiel de service CMOS (VDD) ou par l'intermédiaire de transistors à canal N (TMA2, TSL2) à l'autre source de potentiel de service CMOS (VSS), la borne de drain du transistor à canal P (TMA1, TSL1) étant reliée à la borne de drain du transistor à canal N (TMA2, TSL2) par l'intermédiaire d'un transistor à canal N (TMA3, TSL3) commandé en opposition de phase par rapport à la cadence d'étage respective.
